# EUROPÄISCHE PATENTANMELDUNG

(11) **EP 4 053 920 A1**
(43) Veröffentlichungstag der Anmeldung: **07.09.2022**
(21) Anmeldenummer: 22000042.6
(22) Anmeldetag: 01.03.2022
(51) Int. Cl.: H01L 31/0224

(54) **SOLARZELLENKONTAKTANORDNUNG**

(30) Priorität: 02.03.2021 DE 102021001117; 26.05.2021 DE 102021002720; 20.09.2021 DE 102021004707
(71) Anmelder: AZUR SPACE Solar Power GmbH, 74072 Heilbronn (DE)
(72) Erfinder: Köstler, Wolfgang, 74074 Heilbronn (DE); Kubera, Tim, 74211 Leingarten (DE)
(74) Vertreter: Koch Müller Patentanwaltsgesellschaft mbH

(57) **Zusammenfassung**

Solarzellenkontaktanordnung, aufweisend eine Halbleiterkörper mit einer Oberseite, einer Unterseite, wobei die Halbleiterkörper mehrere Solarzellenstapel aufweist und an der Unterseite ein Trägersubstrat umfasst, und jeder Solarzellenstapel mindestens zwei auf dem Trägersubstrat angeordnete III-V-Teilzellen und mindestens einen von der Oberseite bis zu der Unterseite der Halbleiterkörper reichender Durchgangskontakt mit zusammenhängender Seitenwand aufweist, wobei der Durchgangskontakt an der Oberseite einen ersten Randbereich und an der Unterseite einen zweiten Randbereich aufweist, und der erste Randbereich einen ersten Abschnitt und einen zweiten metallischen Abschnitt aufweist, und der zweite Randbereich einen ersten Abschnitt und einen zweiten Abschnitt aufweist, wobei die jeweiligen zweiten Abschnitte die jeweiligen ersten Abschnitte vollständig umschließen, und eine Isolationsschicht, wobei die Isolationsschicht bei dem ersten Randbereich auf dem ersten Abschnitt, der Seitenwand und bei dem zweiten Randbereich auf dem ersten Abschnitt und dem zweiten Abschnitt ausgebildet ist, eine wenigstens teilweise auf der Isolationsschicht angeordnete elektrisch leitfähige Schicht.

## Beschreibung

Die Erfindung betrifft eine Solarzellenkontaktanordnung.

Um die Abschattung der Vorderseite einer Solarzelle zu reduzieren, ist es möglich, sowohl die positive als auch die negative externe Kontaktfläche auf der Rückseite anzuordnen. Bei sogenannten Metal Wrap Through (MWT) - Solarzellen wird die Solarzellenvorderseite beispielsweise durch eine Durchgangskontaktöffnung von der Rückseite aus kontaktiert.

Es sind unterschiedliche Verfahren zur Herstellung eines Lochs bzw. einer Durchgangskontaktöffnung durch eine Solarzelle bekannt. Die durch die Durchgangsöffnung verlaufende Metallisierung wird mittels einer Isolationsschicht gegenüber den Schichten des Solarzellenstapels isoliert.

Beispielsweise ist aus der US 9,680,035 B1 eine Solarzellenkontaktanordnung mit einem Solarzellenstapel umfassend mehrere III-V-Teilzellen auf einem GaAs-Substrat mit rückseitenkontaktierter Vorderseite bekannt. Hierbei wird ein von der Oberseite der Solarzelle durch die Teilzellen bis in eine noch nicht gedünnte Substratschicht hineinreichendes Loch mittels eines nasschemischen Ätzprozesses erzeugt. Eine Passivierung und Metallisierung der Vorderseite und des Lochs wird vor dem Dünnen der Substratschicht durchgeführt.

Vor diesem Hintergrund besteht die Aufgabe der Erfindung den Stand der Technik weiterzubilden.

Die Aufgabe wird durch eine Vorrichtung mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine Solarzellenkontaktanordnung bereitgestellt.

Die Solarzellenkontaktanordnung umfasst einen Halbleiterkörper mit einer Oberseite und einer Unterseite.

Der Halbleiterkörper umfasst an der Oberseite wenigstens einen Solarzellenstapel und an der Unterseite ein Trägersubstrat.

Jeder Solarzellenstapel umfasst mindestens zwei auf dem Trägersubstrat angeordnete III-V-Teilzellen und mindestens einen von der Oberseite bis zu der Unterseite der Halbleiterkörper reichender Durchgangskontakt.

Der Durchgangskontakt weist eine zusammenhängende Seitenwand mit einen an der Oberseite ausgebildeten ersten Randbereich und an der Unterseite ausgebildeten zweiten Randbereich auf.

Der erste Randbereich weist einen ersten Abschnitt und einen zweiten metallischen Abschnitt und der zweite Randbereich einen ersten Abschnitt und einen zweiten Abschnitt auf.

Des Weiteren ist eine Isolationsschicht bei dem ersten Randbereich auf dem ersten Abschnitt, der Seitenwand und bei dem zweiten Randbereich auf dem ersten Abschnitt und dem zweiten Abschnitt ausgebildet.

Die Isolationsschicht weist eine Dicke zwischen 5 µm und 200 µm auf.

Auch ist eine elektrisch leitfähige Schicht bei dem ersten Randbereich auf dem ersten Abschnitt und dem zweiten Abschnitt, an der Seitenwand und bei dem zweiten Randbereich auf dem ersten Abschnitt ausgebildet, wobei die elektrisch leitfähige Schicht wenigstens teilweise auf der Isolationsschicht angeordnet ist.

Die elektrisch leitfähige Schicht ist als heterogene Schicht mit Gaseinschlüssen ausgebildet und weist eine Dicke zwischen 5 µm bis 200 µm auf.

Es sei angemerkt, dass die Gaseinschlüsse wenigstens ein Volumenprozent und höchstens vierzig Volumenprozent des gesamten Volumens der elektrisch leitfähigen Schicht aufweisen oder die elektrisch leitfähige Schicht Gaseinschlüsse zwischen zwei und zehn Volumenprozent umfasst.

Auf der Oberseite ist die elektrisch leitfähige Schicht bei dem ersten Randbereich über den ersten Abschnitt zumindest teilweise darüber hinaus ausgebildet, um eine vorderseitige Metallstruktur zu kontaktieren.

An der Unterseite ist die elektrische leitfähige Schicht bei dem zweiten Randbereich innerhalb des ersten Abschnitts und nicht auf dem zweiten Abschnitt ausgebildet. Anders ausgedrückt die elektrisch leitfähige Schicht liegt bei dem zweiten Randbereich vollständig auf der Isolationsschicht.

Die elektrisch leitfähige Schicht weist organische Bestandteile auf. In einer Weiterbildung durchläuft die elektrische Schicht einen Temperprozess von wenigstens 200°C und einer Dauer von wenigstens 5 min.

Vorzugsweise ist der Halbleiterkörper als Halbleiterscheibe ausgebildet. In einer Weiterbildung umfasst der Halbleiterkörper mehrere Solarzellenstapel. Vorzugsweise sind auf der Halbleiterscheibe genau zwei Solarzellenstapel ausgebildet.

Vorzugsweise ist elektrisch leitfähige Schicht bei dem zweiten Randbereich ausschließlich auf dem ersten Abschnitt ausgebildet.

Vorzugsweise überdeckt die elektrisch leitfähige Schicht den ersten Abschnitt bei dem zweiten Randbereich wenigstens teilweise oder vollständig.

Vorzugsweise ist die Isolationsschicht bei dem ersten Randbereich ausschließlich auf dem ersten Abschnitt ausgebildet.

Es versteht sich, dass die elektrisch leitfähige Schicht, sofern die Isolationsschicht ausgebildet ist, auf der Isolationsschicht angeordnet ist.

Vorzugsweise besteht zwischen der Isolationsschicht und der elektrischen Schicht eine stoffschlüssige Verbindung.

Es sei angemerkt, dass die Isolationsschicht die Seitenwand, d.h. die zu der Oberfläche senkrecht ausgebildete Fläche des Durchgangskontakts vollständig bedeckt.

Vorzugsweise werden von der Isolationsschicht bei dem ersten Randbereich der erste Abschnitt und bei dem zweiten Randbereich der erste Abschnitt und der zweite Abschnitt jeweils wenigstens teilweise oder vollständig überdeckt.

Es sei angemerkt, dass mit dem Begriff "Isolationsschicht" insbesondere auch ein die Isolationsschicht umfassendes dielektrisches Schichtsystem verstanden wird. Des Weiteren wird mit dem Begriff Randbereich jeweils ein unmittelbar an die Durchgangsöffnung angeordneter Bereich auf der Oberseite und auf der Unterseite bezeichnet.

Es sei angemerkt, dass eine Einstrahlung von Licht auf die Oberseite des Halbleiterkörpers erfolgt. Um möglichst wenig von der Oberseite abzuschatten ist die Oberseite mittels einer metallischen Fingerstruktur elektrisch angeschlossen.

Vorzugsweise nimmt die Bandlücke der III-V Teilzellen von der Oberseite in Richtung des Trägersubstrats von Teilzelle zu Teilzelle ab.

Im Allgemeinen weisen die Teilzellen des jeweiligen Solarzellenstapels eine n auf p Anordnung aus. Es versteht sich, dass zwischen zwei Teilzellen jeweils eine Tunneldiode ausgebildet ist, um die einzelnen Teilzelle aus elektrischer Sicht in Serie zu verschalten. Insbesondere umfasst die oberste Teilzelle eine Verbindung aus InGaP und weist eine Bandlücke größer als 1,7 eV auf.

Es versteht sich, dass auf der Oberseite eine im Allgemeinen fingerförmig ausgeführte Oberseitenmetallisierung angeordnet ist, um die Vorderseite elektrisch anzuschließen. Nachfolgend wird die Oberseitenmetallisierung auch als Metallstruktur bezeichnet.

Es versteht sich das bei jedem Solarzellenstapel mittels einer oder mehrere Durchgangsöffnungen die Oberseite von der Rückseite elektrisch angeschlossen ist.

Vorzugsweise wird vor der Ausbildung der Durchgangsöffnung der Halbleiterkörper, der beispielsweise als Halbleiterscheibe ausgebildet ist und vorzugsweise einen Durchmesser von 100 mm oder 150 mm aufweist, auf die gewünschte Enddicke gedünnt. Hierzu wird auf der Rückseite Trägersubstrat abgetragen.

Des Weiteren sei angemerkt, dass der in einer Weiterbildung als Halbleiterscheibe ausgebildete Halbleiterkörper mehrere nicht vereinzelte Solarzellenstapel aufweist, wobei das Trägersubstrat die Unterseite der Halbleiterkörper ausbildet. Es versteht sich, dass der Solarzellenstapel auch 3 oder 4 oder 5 oder maximal 6 Teilzellen aufweist.

In einer Weiterbildung ist hierbei jeweils genau eine der mehreren Teilzellen als Ge-Teilzelle ausgebildet.

Ein Vorteil der Solarzellenkontaktanordnung besteht darin, dass mittels des Durchgangskontakts eine an der Oberseite ausgebildete Vorderseite des Solarzellenstapels von der Unterseite angeschlossen ist. Anders ausgedrückt, der Solarzellenstapel ist elektrisch ausschließlich von der Rückseite angeschlossen. Es erübrigt sich auf der Vorderseite die Ausbildung von Metallflächen, d.h. Pads. Die Empfangsfläche auf der Vorderseite vergrößert sich und die Effizienz der Anordnung steigt.

Die Ausbildung der Durchkontaktierung, d.h. die Ausbildung eines elektrisehen Anschlusses der Vorderseite von der Rückseite vereinfacht den elektrischen Anschluss des Solarzellenstapels. Ein weiterer Vorteil ist, dass sich beide Kontakte, d.h. der n-Kontakt und der p-Kontakt beispielsweise mit einem einzigen Lötprozessschritt rückseitig anschließen lassen. Hierdurch lässt sich die Ausbeute und die Zuverlässigkeit erhöhen.

Es wird angemerkt, dass die Ausbildung der Solarzellenkontaktanordnung vorzugsweise unter einer oder mehrfachen Anwendung eines Druckverfahren erfolgt. Vorzugsweise wird mittels eines ersten Druckverfahrens die Oberseite und die Rückseite mit der Isolationsschicht und mittels eines zweiten Druckverfahrens die Vorderseite und die Rückseite mit der elektrischen Schicht beschichtet.

Hierbei umfasst das erste Druckverfahren und das zweite Druckverfahren jeweils einen oder mehrere Prozessschritte.

Beispielsweise wird jeweils in einem ersten Prozessschritt jeweils nur eine Seite des Halbleiterkörpers und die Durchgangsöffnung bedruckt und anschließend jeweils in einem zweiten Prozessschritt die andere Seite des Halbleiterkörpers und die Durchgangsöffnung oder unter Ausschluss der Durchgangsöffnung bedruckt.

Alternativ umfasst das erste Druckverfahren und / oder das zweite Druckverfahren nur jeweils einen einzigen Druckschritt bei dem jeweils beide Seiten des Halbleiterkörpers bedruckt werden.

In einer Weiterbildung werden bei dem ersten Prozessschritt und / oder dem zweiten Prozessschritt bei der Durchführung des jeweilig einzigen Druckschritts eine Seite des Halbleiterkörpers mittels eines durch die Durchgangsöffnung hindurch geführten Materials bedruckt.

In dem mittels des Druckverfahrens die jeweiligen Schichten strukturiert aufbringen lassen, erübrigen sich photolithographische Prozessschritte. Anders ausgedrückt, sowohl die Isolationsschicht als auch die elektrisch leitfähige Schicht lassen sich strukturiert zuverlässig und kostengünstig aufbringen.

Ein Vorteil des Druckverfahrens liegt weiterhin darin, dass sich die vorgenannten Schichten ohne weiteres auch bei großen Unterschieden in der Topographie zuverlässig aufbringen lassen. Teure und aufwändige Maskenschritte werden vermieden. Auch lässt sich ein zuverlässiger Schutz der Isolationsschicht Im Bereich der Durchgangsöffnung ausbilden. Insbesondere sind der zeitliche und technische Aufwand sowie der Materialverbrauch im Vergleich zum Stand der Technik mittels Lackmasken gering. Zuverlässigkeit und Ausbeute lassen sich hierdurch erhöhen.

Vorzugsweise werden die Durchgangsöffnung und die an die Durchgangsöffnung angrenzenden Bereiche auf der Oberseite und auf der Unterseite werden ausschließlich mittels des Druckverfahrens bedeckt. Mit dem Verfahren lassen sich auf einfache und kostengünstige Weise hocheffiziente und zuverlässige Mehrfach-Solarzellen herstellen, deren Vorderseite elektrisch an der Rückseite angeschlossen ist.

In einer Weiterbildung ist an der Unterseite des Trägersubstrats in einem ersten Kontaktbereich die elektrisch leitfähige Schicht ausgebildet. Hierdurch lässt sich die Oberseite der Halbleiterscheibe, also die Vorderseite des Solarzellenstapels auf der Rückseite elektrisch anschließen.

In einer anderen Weiterbildung ist an der Unterseite des Trägersubstrats ein zweiter Kontaktbereich ausgebildet. Die Unterseite des elektrisch leitfähigen Trägersubstrats lässt sich mittels des zweiten Kontaktbereichs elektrisch anschließen. Vorzugsweise ist der erste Kontaktbereich als n-Kontakt und der zweite Kontaktbereich als p-Kontakt ausgebildet. Es versteht sich, dass die beiden Kontaktbereiche an der Unterseite zueinander beabstandet sind, um eine elektrische Isolation zu gewährleisten.

In einer anderen Weiterbildung sind beide Kontaktbereiche planar ausgebildet und umfassen jeweils eine Größe von wenigstens 1,0 mm². In einer Ausführungsform weisen beide Kontaktbereiche wenigstens teilweise die gleiche Höhe auf. Anders ausgedrückt, die Oberflächen der beiden Kontaktbereiche sind von der Unterseite des Trägersubstrats gleich weit entfernt. Ein Vorteil ist, dass sich die beiden Kontaktbereiche beispielsweise gleichzeitig mittels eine sogenannten Reflow-Lötschrittes mit einer Unterlage verbinden lassen.

In einer Ausführungsform weist der erste Kontaktbereich, d.h. die elektrisch leitfähige Schicht eine stoffschlüssige Verbindung mit der darunterliegenden Isolationsschicht auf. Insbesondere ist die elektrische Schicht eine vollständige stoffschlüssige Verbindung mit der Isolationsschicht in dem ersten Kotaktbereich auf.

In einer anderen Ausführungsform ist der Durchmesser der Durchgangsöffnung in dem Trägersubstrat von der Oberseite in Richtung der Unterseite in erster Näherung gleich oder genau gleich ist oder bildet einen konischen Verlauf nach.

In einer Weiterbildung ist nach der Ausbildung der leitfähigen Schicht die Durchgangsöffnung teilweise oder vollständig geschlossen oder die Durchgangsöffnung weist noch ein durchgehendes Loch auf.

In einer Ausführungsform weist der erste Randbereich an der Oberseite einen anderen, insbesondere kleineren Durchmesser als der zweite Randbereich an der Unterseite auf.

In einer anderen Ausführungsform sind der erste Randbereich und der zweite Randbereich jeweils als ein vollständig um die Durchgangsöffnung umlaufender Randbereich ausgebildet. Vorzugsweise weist der jeweilige Randbereich parallel zur Halbleiterkörper einen Durchmesser von wenigstens 10 µm und höchstens 3,0 mm auf. Alternativ weist der jeweilige Randbereich parallel zur Halbleiterkörper einen Durchmesser von wenigstens 100 µm und höchstens 1,0 mm auf.

In einer anderen Weiterbildung weist die Durchgangsöffnung der Halbleiterkörper eine Gesamthöhe von höchstens 500 µm und von mindestens 30 µm oder von höchstens 200 µm und von mindestens 50 µm auf.

In einer Ausführungsform weist die Durchgangsöffnung im Querschnitt einen ovalen Umfang, insbesondere einen runden Umfang auf. Vorzugsweise weist die Durchgangsöffnung vor der Anwendung des ersten Druckverfahrens d.h. ohne eine Ausbildung der Isolationsschicht einen Durchmesser zwischen 25 µm und 1 mm auf. Alternativ liegt der Durchmesser der Durchgangsöffnung in einem Bereich zwischen 50 µm bis 300 µm.

In einer anderen Weiterbildung ist das Trägersubstrat elektrisch leitfähig ausgebildet. Vorzugsweise umfasst das Trägersubstrat Germanium oder GaAs oder Silizium oder besteht aus einen der vorgenannten Materialien. Alternativ umfasst das Trägersubstrat eine Metallfolie oder umfasst einen elektrisch leitfähigen Kunststoff.

In einer Ausführungsform ist die Durchgangsöffnung vorzugsweise oval ausgebildet. Vorliegend sind mit dem Begriff "oval" auch runde insbesondere kreisförmige, eiförmige und elliptische Formen umfasst.

In einer anderen Ausführungsform ist die Durchgangsöffnung als viereckige oder quadratische Form mit abgerundeten Ecken ausgebildet.

In einer Weiterbildung wird nach dem ersten Druckverfahren und vor der Durchführung des zweiten Druckverfahrens ein erster Ausheizschritt durchgeführt. In einer anderen Weiterbildung wird nach dem zweiten Druckverfahren ein zweiter Ausheizschritt durchgeführt. Mittels den Ausheizschritten werden die Isolationsschicht und die leitfähige Schicht jeweils konditioniert. Vorzugsweise werden die Ausheizschritte in einem Temperaturbereich zwischen 100°C und 450°C durchgeführt.

In einer Weiterbildung wird zur Ausbildung der Isolationsschicht eine Paste verwendet wird. Vorzugsweise umfasst die Paste organische Bestandteile.

In einer anderen Weiterbildung wird zur Ausbildung der leitfähigen Schicht eine Metallpartikel enthaltene Paste verwendet.

In einer Ausführungsform wird das erste Druckverfahren und / oder das zweite Druckverfahren ausschließlich von der Vorderseite oder ausschließlich von der Rückseite durchgeführt. Alternativ wird das erste Druckverfahren und / oder das zweite Druckverfahren sowohl von der Vorderseite als auch von der Rückseite durchgeführt.

In einer anderen Ausführungsform weist die Durchgangsöffnung nach der Ausbildung der Isolationsschicht noch ein durchgehendes Loch auf. Alternativ wird die Durchgangsöffnung mittels eines Lasers in einem zentralen Bereich geöffnet.

Vorzugsweise besteht die leitfähige Schicht auf dem ersten Randbereich und in der Durchgangsöffnung und auf dem zweiten Randbereich aus dem gleichen Material. In einer alternativen Ausführungsform werden zur Ausbildung der leitfähigen Schicht auf der Oberseite und auf der Unterseite unterschiedliche Zusammensetzungen verwendet.

Sofern die Durchgangsöffnung mittels der leitfähigen Schicht vollständig geschlossen ist, steht in einer Weiterbildung die leitfähige Schicht über die Oberseite und / oder an der Unterseite hinaus. Alternativ bildet die leitfähige Schicht an der Unterseite auf der Isolationsschicht mit der leitfähigen Schicht in dem Zentrum der Durchgangsöffnung eine in einer ersten Näherung planen Fläche aus.

In einer Weiterbildung wird das Druckverfahren mittels ein Inkjet-Verfahrens oder einem Siebdruckverfahren oder mittels einem ein Dispens-Verfahren durchgeführt. Alternativ wird das Druckverfahren mittels eines Schablonendruckverfahrens durchgeführt. In einer anderen Weiterbildung werden wenigstens zwei der unterschiedlichen Druckverfahren kombiniert.

In einer Weiterbildung ist der Durchmesser der Durchgangsöffnung vor der Anwendung des Druckverfahrens in dem Trägersubstrat von Richtung Oberseite aus hin zur Unterseite in erster Näherung oder genau gleich.

Alternativ wird der Durchmesser der Durchgangsöffnung von der Oberseite in Richtung zu der Unterseite kleiner, wobei die Verjüngung vorzugsweise stufenmäßig ausgebildet ist. In einer Weiterbildung weist die Durchgangsöffnung eine sanduhrförmige Ansicht in einem Querschnitt auf. Hierbei verjüngt sich der Querschnitte bis etwa zur Hälfte der Gesamtdicke.

In einer anderen Weiterbildung umfasst die Verjüngung in der Durchgangsöffnung genau eine vollständig umlaufende Stufe oder genau zwei vollständig umlaufende Stufen.

Vorzugsweise weist die Halbleiterkörper oder das Trägersubstrat eine Größe von 100 mm oder 150 mm oder größer auf.

Umfasst oder besteht das Trägersubstrat aus Germanium, bildet das Ge-Trägersubstrat die Unterseite der Halbleiterkörper aus. Vorzugsweise ist in dem Ge-Trägersubstrat auf der von der Unterseite abgewandten Seite eine erste Teilzelle als Ge-Teilzelle ausgebildet, wobei die Ge-Teilzelle die kleinste Bandlücke der Teilzellen des Solarzellenstapels aufweist.

Bei der Verwendung von Ge als Trägersubstrat ist eine erste Stufe an der Grenzfläche zwischen Ge-Teilzelle und den aufliegenden III-V Teilzellen ausgebildet. Eine zweite Stufe ist vorzugsweise zwischen der Ge-Teilzelle und dem Ge-Substrat ausgebildet.

Vorzugsweise verjüngt sich die Durchgangsöffnung auch innerhalb des Ge-Substrats. Die stufenförmige bzw. konische Ausführung der Durchgangsöffnung hat den Vorteil, dass sich insbesondere bei einer vorzugsweise konformen Abscheidung der Isolationsschicht und / oder weiteren aufzubringenden Schichten im Rahmen einer Metallisierung die Dicke der Schichten sind auf den Seitenflächen hinreichend ausbilden lässt.

In einer Weiterbildung ist.eine weitere Stufe an der Oberseite der Halbleiterkörper an der Grenzfläche zwischen Metallstruktur und der Oberseite der obersten III-V Teilzelle ausgebildet.

In einer Ausführungsform weist der Solarzellenstapel eine Ge-Teilzelle auf. In Folge umfasst der Solarzellenstapel wenigstens 3 Teilzellen.

In einer anderen Ausführungsform wird ein Teil der Isolationsschicht auf der Oberseite auf einer Metallfläche ausgebildet. Hierdurch lässt sich sicherstellen, dass auf der Oberseite die Metallstruktur, d.h. die Vorderseite des Solarzellenstapels angeschlossen wird.

Anders ausgedrückt, indem die leitfähige Schicht auf der Oberseite die Isolationsschicht übergreift und eine stoffschlüssige Verbindung mit einem Teil der Metallstruktur ausbildet und auf der Unterseite jedoch nur den unmittelbar an die Durchgangsöffnung angrenzenden Teil des zweiten Randbereichs bedeckt, wird hierdurch an der Unterseite einen Kontaktbereich für einen elektrischen Anschluss der Metallstruktur MV ausgebildet.

In einer Weiterbildung umschließen die jeweiligen zweiten Abschnitte die jeweiligen ersten Abschnitte vollständig.

In einer Ausführungsform liegt der Anteil der organischen Bestandteile In der elektrischen Schicht zwischen 0,1 und 5 Volumenprozent oder zwischen 0,2 und 2 Volumenprozent. Es versteht sich, dass die elektrische Schicht mittels des Druckverfahrens unter Verwendung einer metallorganischen Paste auf die Oberfläche aufgebracht wird.

In einer anderen Weiterbildung beträgt die Dicke des Teils der elektrischen Schicht unmittelbar an Kante des ersten Randbereichs hin zu der Durchgangsöffnung wenigstens die Hälfte der Dicke des auf dem zweiten Randbereich aufliegenden Teils der elektrischen Schicht.

In einer Weiterbildung ist die Durchgangsöffnung nach der Ausbildung der elektrischen Schicht vollständig ausgefüllt.

In einer anderen Ausführungsform umfasst die Isolationsschicht organische Anteile. Vorzugsweise liegt der Anteil der organischen Anteile in einem Bereich zwischen 0,1 % bis 5 % Volumenprozent.

In einer Weiterbildung weist die Isolationsschicht eine Dicke zwischen 5 µm und 200 µm oder zwischen 5 µm und 250 µm und / oder die elektrisch leitfähige Schicht eine Dicke zwischen 5 µm bis 500 µm auf. In einer anderen Weiterbildung liegt die Dicke der Isolationsschicht zwischen 10 µm bis 100 µm und / oder die Dicke der elektrisch leitfähigen Schicht zwischen 10 µm bis 200 µm.

In einer Ausführungsform weist die elektrisch leitfähige Schicht einen Metallvolumenanteil von weniger als 99% und mehr als 50% auf.

In einer anderen Ausführungsform liegt elektrische Leitfähigkeit zwischen 30 % und 90% der Metall-Konduktivität einer homogen mit in einer ersten Näherung gleichen stofflichen Zusammensetzung ausgebildeten Metallschicht.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und die vertikale Erstreckung sind nicht maßstäblich und weisen, sofern nicht anders angegeben, auch keine ableitbaren geometrischen Relationen zueinander auf. Darin zeigen, die
- Figur 1: eine Querschnittsansicht einer metallisierten Durchgangsöffnung in einer Ausführungsform,
- Figur 2: eine Querschnittsansicht einer metallisierten Durchgangsöffnung in einer weiteren Ausführungsform,
- Figur 3: eine Querschnittsansicht einer metallisierten Durchgangsöffnung in einer anderen Ausführungsform,
- Figur 4a: eine Draufsicht auf die Oberseite der metallisierten Durchgangsöffnung entsprechend der Ausführungsform, dargestellt in Zusammenhang mit der Abbildung der Figur 3,
- Figur 4b: eine Draufsicht auf die Unterseite der metallisierten Durchgangsöffnung entsprechend der Ausführungsform, dargestellt in Zusammenhang mit der Abbildung der Figur 3,
- Figur 5: eine Querschnittsansicht einer metallisierten Durchgangsöffnung mit einem ersten Kontaktbereich und einem zweiten Kontaktbereich.
- Figur 6: eine Draufsicht auf eine Halbleiterkörper mit zwei Solarzellenstapel.

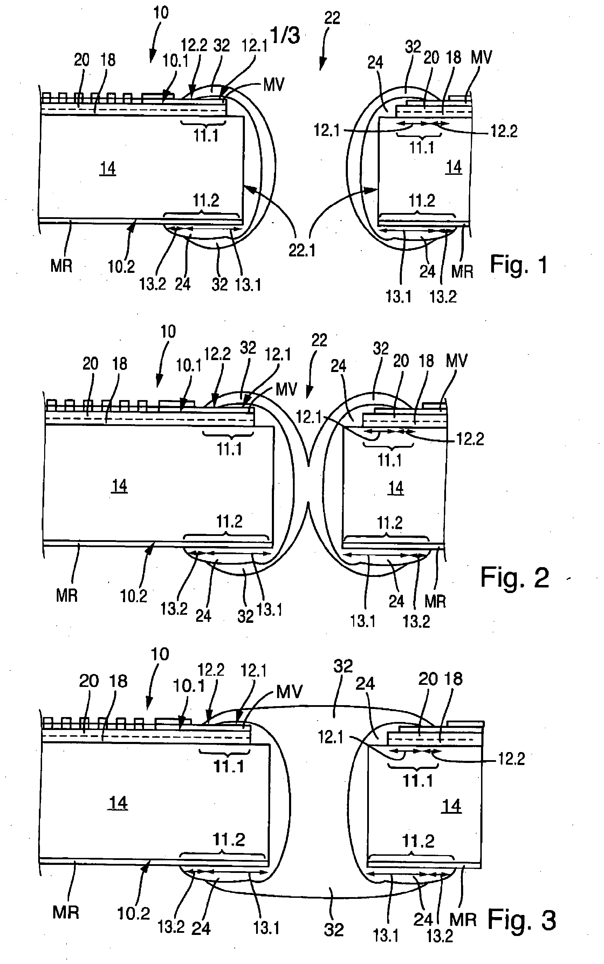

Die Abbildungen der Figur 1 zeigt Querschnittsansicht einer metallisierten Durchgangsöffnung 22 einer Halbleiterkörper 10.

Es wird eine Halbleiterkörper 10 mit einer Oberseite 10.1, einer Unterseite 10.2 und einer von der Oberseite 10.1 bis zu der Unterseite 10.2 erstreckenden Durchgangsöffnung 22 mit einer zusammenhängenden Seitenwand 22.1 bereitgestellt.

Die Halbleiterkörper 10 umfasst mehrere noch nicht vereinzelte Solarzellenstapel 12, dargestellt ist vorliegend nur ein Solarzellenstapel 12, jeweils mit einer Schichtfolge aus einem die Unterseite 10.2 ausbildenden Trägersubstrat 14, einer ersten III-V-Teilzelle 18 und einer die Oberseite 10.1 ausbildenden zweiten III-V-Teilzelle 20.

Auf der Oberseite 10.1 ist eine Metallstruktur MV ausgebildet. Die Metallstruktur MV ist fast ausschließlich als fingerförmige Struktur ausgebildet und weist insbesondere in dem ersten Randbereich 11.1 der Durchgangsöffnung 22 eine um vollständig um die Durchgangsöffnung 22 ausgebildete zusammenhängende Metallfläche aus.

Auf der Unterseite 10.2 ist eine ganzflächige Rückseitenmetallisierung MR ausgebildet, um das leitfähige Trägersubstrat 14 anzuschließen. Es versteht sich das mit den beiden Metallisierungen MV und MR der jeweilige Solarzellenstapel 12 elektrisch angeschlossen wird.

Die Durchgangsöffnung 22 weist an der Oberseite 10.1 einen ersten Randbereich 11.1 und an der Unterseite 10.2 einen zweiten Randbereich 11.2 auf. Der erste Randbereich 11.1 ist unmittelbar auf der Metallstruktur MV und der zweite Randbereich 11.2 ist unmittelbar auf der Rückseitenmetallisierung MR ausgebildet.

Der erste Randbereich 11.1 weist einen ersten Abschnitt 12.1 und einen zweiten metallischen Abschnitt 12.2 auf. Der zweite Randbereich 11.2 weist einen ersten Abschnitt 13.1 und einen zweiten Abschnitt 13.2 auf. Nachfolgend wird der erste Abschnitt 12.1 des ersten Randbereich 11.1 und der zweite Abschnitt 12.2. des ersten Randbereichs 11.1 auch als erster Teil bzw. als zweiten Teil des ersten Randbereichs bezeichnet.

Entsprechend wird der erste Abschnitt 13.1 und der zweite Abschnitt 13.2 des zweiten Randbereichs 11.2 auch als erster Teil bzw. als zweiten Teil des zweiten Randbereichs 11.2 bezeichnet.

Ein unmittelbar um die Durchgangsöffnung 22 ausgebildeter Teil des ersten Randbereichs 11.1. und der gesamte zweite Randbereich 11.2 sowie die Seitenwand 22.1 der Durchgangsöffnung 22 sind mit einer Isolationsschicht 24 beschichtet, wobei die Isolationsschicht 24 mit einem ersten Druckverfahren ausgebildet wird. Es versteht sich, dass die Seitenwand 22.1 in der Durchgangsöffnung 22 vollständig von der Isolationsschicht 24 bedeckt ist.

Mittels eines zweiten Druckverfahrens wird eine leitfähige Schicht 32 auf das gesamte Gebiet des ersten Randbereich 11.1 und vollständig auf die gesamte Fläche der Seitenwand 22.1 und auf unmittelbar einen an die Durchgangsöffnung 22 angrenzenden Teil des zweiten Randbereich 11.2 aufgebracht. Vorliegend ist die Durchgangsöffnung 22 auch nach der Ausbildung der leitfähigen Schicht 32 noch offen.

Indem die leitfähige Schicht 32 auf der Oberseite 10.1 die Isolationsschicht 24 übergreift und eine stoffschlüssige Verbindung mit einem Teil der Metallstruktur MV ausbildet und auf der Unterseite 10.2 jedoch nur den unmittelbar an die Durchgangsöffnung 22 angrenzenden Teil des zweiten Randbereich 11.2 bedeckt, wird hierdurch an der Unterseite 10.2 einen Kontaktbereich für einen Anschluss der Metallstruktur MV ausgebildet.

In der Abbildung der Figur 2 ist eine weitere Ausführungsform dargestellt. Im Folgenden werden nur die Unterschiede zu der Abbildung der Figur 1 erläutert.

In der dargestellten Ausführungsform stößt die leitfähige Schicht 32 in der Mitte des Substrats 14 zusammen und bildet ein Profil in Form einer Sanduhr aus.

In der Abbildung der Figur 3 ist eine andere Ausführungsform dargestellt. Im Folgenden werden nur die Unterschiede zu der Abbildung der Figur 1 erläutert.

In der dargestellten Ausführungsform wird die Durchgangsöffnung 22 vollständig von der leitfähigen Schicht 32 ausgefüllt und bildet eine aus Oberseite 10.1 und eine aus der Unterseite 10.2 hinausstehende Erhebung aus.

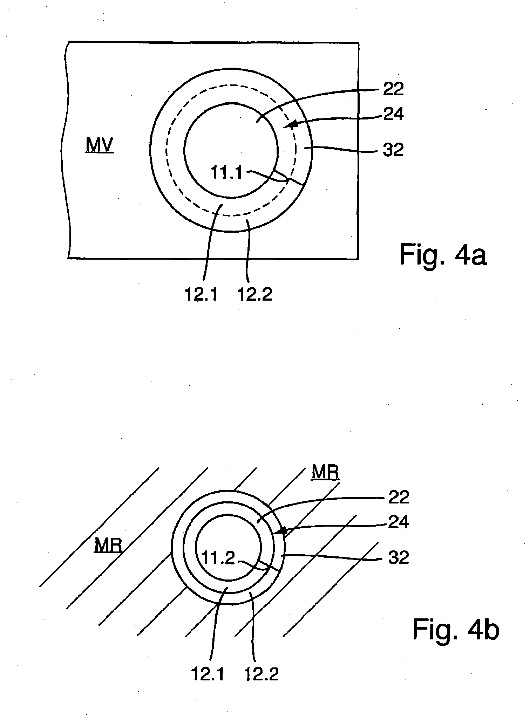

In der Abbildung der Figur 4a ist eine Draufsicht auf die Oberseite der metallisierten Durchgangsöffnung 22 entsprechend der Ausführungsform, dargestellt in Zusammenhang mit der Abbildung der Figur 3, abgebildet.

Der erste Randbereich 11.1, als Teil des Metallstruktur MV, umschließt die Durchgangsöffnung 22 vollständig. Der mit der Isolationsschicht 24 bedeckte Teil des ersten Randbereichs 11.1 ist gestrichelt eingezeichnet. Es zeigt sich, dass die leitfähige Schicht 22 die Isolationsschicht 24 auf der Oberseite 10.1 vollständig überdeckt.

In der Abbildung der Figur 4b ist eine Draufsicht auf die Unterseite der metallisierten Durchgangsöffnung 22 entsprechend der Ausführungsform, dargestellt in Zusammenhang mit der Abbildung der Figur 3, abgebildet.

Der zweite Randbereich 11.2, als Teil der Rückseitenmetallisierung MR, umschließt die Durchgangsöffnung 22 vollständig. Der mit der Isolationsschicht 24 bedeckte Teil des zweiten Randbereichs 11.2 ist nunmehr größer als der Teil bedeckt mit der leitfähigen Schicht 22. Anders ausgedrückt die leitfähige Schicht 22 überdeckt die Isolationsschicht 24 auf der Unterseite 10.2 nur teilweise.

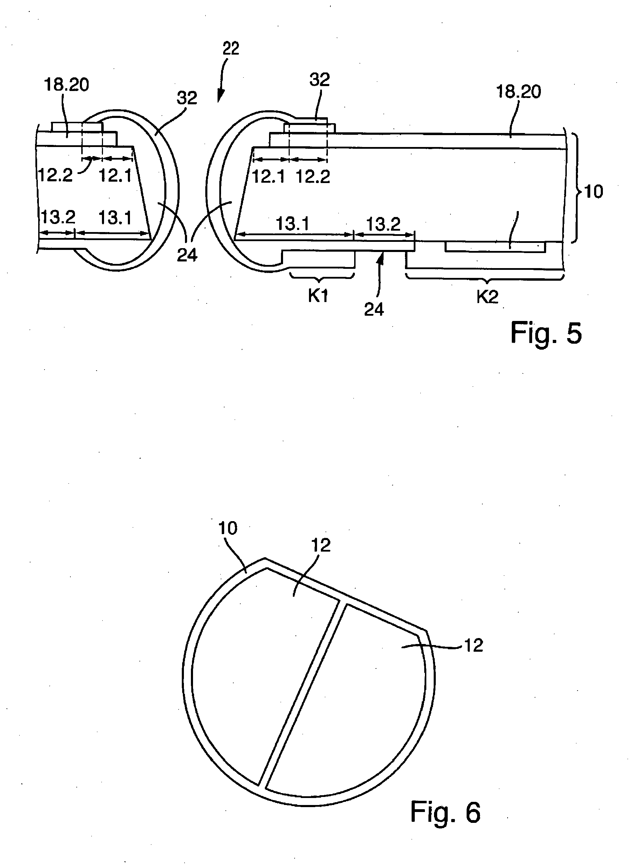

In der Abbildung der Figur 5 eine weitere Querschnittsansicht einer metallisierten Durchgangsöffnung dargestellt. Im Folgenden werden nur die Unterschiede zu der Abbildung der Figur 1 und der Abbildung der Figur 4b erläutert.

An der Unterseite 10.2 ist der erste Abschnitt 13.1 des zweiten Randbereich 11.2 wenigstens auf der rechten Seite der Durchgangsöffnung 22 verbreitert, um einen ersten Kontaktbereich K1 auszubilden. Auf dem zweiten Abschnitt 13.2 des zweiten Randbereich 11.2 ist die Unterseite 10.2 nur mit der Isolationsschicht 24 bedeckt.

An der Unterseite 10.2 ist anschließend an den zweiten Abschnitt 24 ein zweiter Kontaktbereich K2 als Teil der Rückseitenmetallisierung MR ausgebildet.

In einem Teil des zweiten Kontaktbereichs K2 ist auf der Unterseite 10.2 zur Justierung der Höhe des zweiten Kontaktbereichs K2 ebenfalls die Isolationsschicht 24 ausgebildet. Anders ausgedrückt die Rückseitenmetallisierung MR ist in dem zweiten Kontaktbereich K2 stoffschlüssig auf der Isolationsschicht 24 ausgebildet.

Hierdurch lassen sich die beiden Oberflächen des ersten Kontaktbereich K1 und des zweiten Kontaktbereichs K2 derart justieren, um beide Kontaktbereiche K1 und K2 gleichzeitig zu löten.

In der Abbildung der Figur 6 ist eine Draufsicht auf einen Halbleiterkörper 10 mit zwei Solarzellenstapel dargestellt. Vorliegend weist die Halbleiterkörper 10 genau zwei Solarzellenstapel 12 auf. Es versteht sich, dass in nicht dargestellten Ausführungsformen auch mehr als zwei Solarzellenstapel 12 auf der Halbleiterkörper 10 ausgebildet sind.

## Patentansprüche

1. Solarzellenkontaktanordnung, aufweisend
- ein Halbleiterkörper (10) mit einer Oberseite (10.1), einer Unterseite (10.2), wobei der Halbleiterkörper (10) wenigstens ein Solarzellenstapel (12) aufweist und an der Unterseite ein Trägersubstrat (14) umfasst,
- jeder Solarzellenstapel (12) mindestens zwei auf dem Trägersubstrat (14) angeordnete III-V-Teilzellen (18, 20) und mindestens einen von der Oberseite (10.1) bis zu der Unterseite (10.2) des Halbleiterkörpers (10) reichender Durchgangskontakt (22) mit zusammenhängender Seitenwand (22.1) aufweist, wobei
der Durchgangskontakt (22) an der Oberseite (10.1) einen ersten Randbereich (11.1) und an der Unterseite (10.2) einen zweiten Randbereich (11.2) aufweist, und
der erste Randbereich (11.1) einen ersten Abschnitt (12.1) und einen zweiten metallischen Abschnitt (12.2) aufweist, und
der zweite Randbereich (11.2) einen ersten Abschnitt (13.1) und einen zweiten Abschnitt (13.2) aufweist, wobei
- eine Isolationsschicht (24) mit einer Dicke von 5 µm bis 200 µm, wobei die Isolationsschicht (24) bei dem ersten Randbereich (11.1) auf dem ersten Abschnitt (12.1), der Seitenwand (22.1) und bei dem zweiten Randbereich (11.2) auf dem ersten Abschnitt (13.1) und dem zweiten Abschnitt (13.2) ausgebildet ist,
- eine elektrisch leitfähige Schicht (32), wobei die elektrisch leitfähige Schicht (32) als heterogene Schicht mit Einschlüssen von Gas ausgebildet ist, und
die elektrisch leitfähige Schicht eine Dicke zwischen 5 µm bis 200 µm aufweist, und
die elektrisch leitfähige Schicht bei dem ersten Randbereich (11.1) auf dem ersten Abschnitt (12.1) und zumindest teilweise dem zweiten Abschnitt (12.2), an der Seitenwand (22.1) und
bei dem zweiten Randbereich (11.2) die elektrisch leitfähige Schicht innerhalb des ersten Abschnittes (13.1) ausgebildet ist, und
die elektrisch leitfähige Schicht (32) auf der Isolationsschicht (24) angeordnet ist.

2. Solarzellenkontaktanordnung nach Anspruch 1, **dadurch gekennzeichnet, dass** die elektrisch leitfähige Schicht (32) an der Unterseite des Trägersubstrats (14) einen ersten Kontaktbereich (K1) ausbildet.

3. Solarzellenkontaktanordnung nach Anspruch 1 oder Anspruch 2, **dadurch gekennzeichnet, dass** an der Unterseite des Trägersubstrats (14) ein zweiter Kontaktbereich (K2) ausgebildet ist und mittels des zweiten Kontaktbereichs (K2) das Trägersubstrat (14) an der Unterseite (10.2) elektrisch angeschlossen ist.

4. Solarzellenkontaktanordnung nach einem der Ansprüche 2 oder 3, **dadurch gekennzeichnet, dass** der Solarzellenstapel (12) elektrisch mittels des ersten Kontaktbereichs (K1) und mittels des zweiten Kontaktbereichs (K2) angeschlossen ist.

5. Solarzellenkontaktanordnung nach einem der Ansprüche 2 oder 3, **dadurch gekennzeichnet, dass** die beiden Kontaktbereiche (K1, K2) planar ausgebildet sind und jeweils eine Größe von wenigstens 1,0 mm² aufweisen.

6. Solarzellenkontaktanordnung nach einem der Ansprüche 2 bis 5, **dadurch gekennzeichnet, dass** beide Kontaktbereiche (K1, K2) wenigstens teilweise die gleiche Höhe aufweisen.

7. Solarzellenkontaktanordnung nach einem der vorstehenden Ansprüche, **dadurch gekennzeichnet, dass** nach der Ausbildung der leitfähigen Schicht (32) die Durchgangsöffnung teilweise oder vollständig geschlossen ist oder die Durchgangsöffnung noch ein durchgehendes Loch aufweist.

8. Solarzellenkontaktanordnüng nach einem der vorstehenden Ansprüche, **dadurch gekennzeichnet, dass** erste Randbereich (11.1) einen kleineren Durchmesser als der zweite Randbereich (11.2) aufweist.

9. Solarzellenkontaktanordnung nach einem der vorstehenden Ansprüche, **dadurch gekennzeichnet, dass** der erste Randbereich (11.1) und der zweite Randbereich (11.2) jeweils als ein vollständig um die Durchgangsöffnung (22) umlaufender Randbereich ausgebildet sind und der jeweilige Randbereich (11.1, 11.2) parallel zur Halbleiterkörper (10) einen Durchmesser von wenigstens 10 µm und höchstens 3,0 mm aufweist.

10. Solarzellenkontaktanordnung nach einem der vorstehenden Ansprüche, **dadurch gekennzeichnet, dass** vor der Ausbildung der Isolationsschicht (24) und der leitfähigen Schicht (32) die Durchgangsöffnung (22) einen Durchmesser zwischen 25 µm und 1 mm aufweist.

11. Solarzellenkontaktanordnung nach einem der vorstehenden Ansprüche, **dadurch gekennzeichnet, dass** die jeweiligen zweiten Abschnitte (12.2, 13.2) die jeweiligen ersten Abschnitte (12.1, 13.1) vollständig umschließen.

12. Solarzellenkontaktanordnung nach einem der vorstehenden Ansprüche, **dadurch gekennzeichnet, dass** der Anteil der organischen Bestandteile in der elektrischen Schicht (32) zwischen 0,1 und 5 Volumenprozent oder zwischen 0,2 und 2 Volumenprozent liegt.

13. Solarzellenkontaktanordnung nach einem der vorstehenden Ansprüche, **dadurch gekennzeichnet, dass** die Dicke des Teils der elektrischen Schicht unmittelbar an Kante des ersten Randbereichs (11.1) hin zu der Durchgangsöffnung (22) wenigstens die Hälfte der Dicke des auf dem zweiten Randbereich (11.2) aufliegenden Teil der elektrischen Schicht (32) beträgt.

14. Solarzellenkontaktanordnung nach einem der vorstehenden Ansprüche, **dadurch gekennzeichnet, dass** die Durchgangsöffnung nach der Ausbildung der elektrischen Schicht vollständig ausgefüllt ist.

15. Solarzellenkontaktanordnung nach einem der vorstehenden Ansprüche, **dadurch gekennzeichnet, dass** die Isolationsschicht (24) organische Anteile in einem Bereich zwischen 0,1 bis 5 Volumenprozent umfasst.

16. Solarzellenkontaktanordnung nach einem der vorstehenden Ansprüche, **dadurch gekennzeichnet, dass** die Isolationsschicht (24) eine Dicke zwischen 5 µm bis 250 µm und / oder die elektrisch leitfähige Schicht (32) eine Dicke zwischen 5 µm bis 500 µm aufweist.

17. Solarzellenkontaktanordnung nach einem der vorstehenden Ansprüche, **dadurch gekennzeichnet, dass** und einen Metallvolumenanteil von weniger als 99% und mehr als 50% aufweist, und eine maximale elektrische Leitfähigkeit zwischen 30 % und 90% der Metall-Konduktivität einer homogen mit einer in erster Näherung gleichen stoffliche Zusammensetzung ausgebildeten Metallschicht.

## Geänderte Patentansprüche

### Geänderte Patentansprüche gemäss Regel 137(2) EPÜ.

1. Solarzellenkontaktanordnung, aufweisend
- ein Halbleiterkörper (10) mit einer Oberseite (10.1), einer Unterseite (10.2), wobei der Halbleiterkörper (10) wenigstens ein Solarzellenstapel (12) aufweist und an der Unterseite ein Trägersubstrat (14) umfasst,
- jeder Solarzellenstapel (12) mindestens zwei auf dem Trägersubstrat (14) angeordnete III-V-Teilzellen (18, 20) und mindestens einen von der Oberseite (10.1) bis zu der Unterseite (10.2) des Halbleiterkörpers (10) reichender Durchgangskontakt (22) mit zusammenhängender Seitenwand (22.1) aufweist, wobei
der Durchgangskontakt (22) an der Oberseite (10.1) einen ersten Randbereich (11.1) und an der Unterseite (10.2) einen zweiten Randbereich (11.2) aufweist, und
der erste Randbereich (11.1) einen ersten Abschnitt (12.1) und einen zweiten metallischen Abschnitt (12.2) aufweist, und
der zweite Randbereich (11.2) einen ersten Abschnitt (13.1) und einen zweiten Abschnitt (13.2) aufweist, wobei
- eine Isolationsschicht (24) vorgesehen ist, wobei die Isolationsschicht (24) bei dem ersten Randbereich (11.1) auf dem ersten Abschnitt (12.1), der Seitenwand (22.1) und bei dem zweiten Randbereich (11.2) auf dem ersten Abschnitt (13.1) und dem zweiten Abschnitt (13.2) ausgebildet ist,
- eine elektrisch leitfähige Schicht (32), und
die elektrisch leitfähige Schicht eine Dicke zwischen 5 µm bis 200 µm aufweist, und
die elektrisch leitfähige Schicht bei dem ersten Randbereich (11.1) auf dem ersten Abschnitt (12.1) und zumindest teilweise dem zweiten Abschnitt (12.2), an der Seitenwand (22.1) und
bei dem zweiten Randbereich (11.2) die elektrisch leitfähige Schicht innerhalb des ersten Abschnittes (13.1) ausgebildet ist, und
die elektrisch leitfähige Schicht (32) auf der Isolationsschicht (24) angeordnet ist,
**dadurch gekennzeichnet, dass**
die Isolationsschicht (24) eine Dicke von 5 µm bis 200 µm aufweist und die elektrisch leitfähige Schicht (32) als heterogene Schicht mit Einschlüssen von Gas ausgebildet ist.

2. Solarzellenkontaktanordnung nach Anspruch 1, **dadurch gekennzeichnet, dass** die elektrisch leitfähige Schicht (32) an der Unterseite des Trägersubstrats (14) einen ersten Kontaktbereich (K1) ausbildet.

3. Solarzellenkontaktanordnung nach Anspruch 1 oder Anspruch 2, **dadurch gekennzeichnet, dass** an der Unterseite des Trägersubstrats (14) ein zweiter Kontaktbereich (K2) ausgebildet ist und mittels des zweiten Kontaktbereichs (K2) das Trägersubstrat (14) an der Unterseite (10.2) elektrisch angeschlossen ist.

4. Solarzellenkontaktanordnung nach einem der Ansprüche 2 oder 3, **dadurch gekennzeichnet, dass** der Solarzellenstapel (12) elektrisch mittels des ersten Kontaktbereichs (K1) und mittels des zweiten Kontaktbereichs (K2) angeschlossen ist.

5. Solarzellenkontaktanordnung nach einem der Ansprüche 2 oder 3, **dadurch gekennzeichnet, dass** die beiden Kontaktbereiche (K1, K2) planar ausgebildet sind und jeweils eine Größe von wenigstens 1,0 mm² aufweisen.

6. Solarzellenkontaktanordnung nach einem der Ansprüche 2 bis 5, **dadurch gekennzeichnet, dass** beide Kontaktbereiche (K1, K2) wenigstens teilweise die gleiche Höhe aufweisen.

7. Solarzellenkontaktanordnung nach einem der vorstehenden Ansprüche, **dadurch gekennzeichnet, dass** nach der Ausbildung der leitfähigen Schicht (32) die Durchgangsöffnung teilweise oder vollständig geschlossen ist oder die Durchgangsöffnung noch ein durchgehendes Loch aufweist.

8. Solarzellenkontaktanordnung nach einem der vorstehenden Ansprüche, **dadurch gekennzeichnet, dass** erste Randbereich (11.1) einen kleineren Durchmesser als der zweite Randbereich (11.2) aufweist.

9. Solarzellenkontaktanordnung nach einem der vorstehenden Ansprüche, **dadurch gekennzeichnet, dass** der erste Randbereich (11.1) und der zweite Randbereich (11.2) jeweils als ein vollständig um die Durchgangsöffnung (22) umlaufender Randbereich ausgebildet sind und der jeweilige Randbereich (11.1, 11.2) parallel zur Halbleiterkörper (10) einen Durchmesser von wenigstens 10 µm und höchstens 3,0 mm aufweist.

10. Solarzellenkontaktanordnung nach einem der vorstehenden Ansprüche, **dadurch gekennzeichnet, dass** vor der Ausbildung der Isolationsschicht (24) und der leitfähigen Schicht (32) die Durchgangsöffnung (22) einen Durchmesser zwischen 25 µm und 1 mm aufweist.

11. Solarzellenkontaktanordnung nach einem der vorstehenden Ansprüche, **dadurch gekennzeichnet, dass** die jeweiligen zweiten Abschnitte (12.2, 13.2) die jeweiligen ersten Abschnitte (12.1, 13.1) vollständig umschließen.

12. Solarzellenkontaktanordnung nach einem der vorstehenden Ansprüche, **dadurch gekennzeichnet, dass** der Anteil der organischen Bestandteile in der elektrischen Schicht (32) zwischen 0,1 und 5 Volumenprozent oder zwischen 0,2 und 2 Volumenprozent liegt.

13. Solarzellenkontaktanordnung nach einem der vorstehenden Ansprüche, **dadurch gekennzeichnet, dass** die Dicke des Teils der elektrischen Schicht unmittelbar an Kante des ersten Randbereichs (11.1) hin zu der Durchgangsöffnung (22) wenigstens die Hälfte der Dicke des auf dem zweiten Randbereich (11.2) aufliegenden Teil der elektrischen Schicht (32) beträgt.

14. Solarzellenkontaktanordnung nach einem der vorstehenden Ansprüche, **dadurch gekennzeichnet, dass** die Durchgangsöffnung nach der Ausbildung der elektrischen Schicht vollständig ausgefüllt ist.

15. Solarzellenkontaktanordnung nach einem der vorstehenden Ansprüche, **dadurch gekennzeichnet, dass** die Isolationsschicht (24) organische Anteile in einem Bereich zwischen 0,1 bis 5 Volumenprozent umfasst.

16. Solarzellenkontaktanordnung nach einem der vorstehenden Ansprüche, **dadurch gekennzeichnet, dass** die Isolationsschicht (24) eine Dicke zwischen 5 µm bis 250 µm und / oder die elektrisch leitfähige Schicht (32) eine Dicke zwischen 5 µm bis 500 µm aufweist.

17. Solarzellenkontaktanordnung nach einem der vorstehenden Ansprüche, **dadurch gekennzeichnet, dass** und einen Metallvolumenanteil von weniger als 99% und mehr als 50% aufweist, und eine maximale elektrische Leitfähigkeit zwischen 30 % und 90% der Metall-Konduktivität einer homogen mit einer in erster Näherung gleichen stoffliche Zusammensetzung ausgebildeten Metallschicht.
